# EUROPÄISCHE PATENTANMELDUNG

(11) **EP 4 095 632 A1**
(43) Veröffentlichungstag der Anmeldung: **30.11.2022**
(21) Anmeldenummer: 21176513.6
(22) Anmeldetag: 28.05.2021
(51) Int. Cl.: G05B 19/418, G05B 19/042

(54) **VERFAHREN UND SYSTEM ZUM MANAGEN VON ALARMEN IN MODULAREN PRODUKTIONSANLAGEN**

(71) Anmelder: Siemens Aktiengesellschaft, 80333 München (DE)
(72) Erfinder: Botero Halblaub, Andrés, 85614 Kirchseeon (DE); Heinzerling, Till, 76185 Karlsruhe (DE); Maurmaier, Mathias, 70839 Gerlingen (DE); Schenk, Tim, 84034 Landshut (DE); Stutz, Andreas, 76344 Eggenstein-Leopoldshafen (DE); Wincheringer, Christoph, 81369 München (DE)

(57) **Zusammenfassung**

Um beim Managen von Alarmen in modularen Produktionsanlagen das Alarmmanagement zu automatisieren, wird es vorgeschlagen, in Bezug auf eine modulare Produktionsanlage (PRAL), z.B. eine Industrieautomatisierungsanlage, bei der für deren modularen, herstellerunabhängigen Aufbau und Betrieb "Process Equipment Assembly <PEA>"-Module (PEA-MD), gesteuert durch eine programmierbare PEA-Steuerung (PEA-ST) und simuliert mit einer projektierbaren PEA-Simulation (PEA-SM), im Zuge einer, insbesondere nach dem Standard VDI/VDE/NAMUR 2658, standardisierten Prozess-Orchestrierung (PO) durch einen "Module Type Package <MTP>"-Mechanismus (MTP-MC) zur PEA-Modulbeschreibung in die Produktionsanlage (PRAL) integriert werden, beim Alarmmanagement
- alle Zustände der modularen Produktionsanlage in Bezug auf ausgelöste Fehler (FHL) möglicher Fehlerfälle (FHLF) der Produktionsanlage virtuell abzufahren und zu simulieren,
- dabei auftretende Simulationsfehler (SMF) durch kenntlichmachende, z.B. durch Signalgebung, Alarme in Form von Alarmmeldungen (AM) begleitend zu protokollieren und ein Alarmmeldungsprotokoll (AMP) zu erstellen sowie oder Alarmketten (AMK) zu identifizieren und Alarmzusammenhänge (AZH) in den Alarmketten (AMK) zu ermitteln.

## Beschreibung

Die Erfindung bezieht sich auf ein Verfahren zum Managen von Alarmen in modularen Produktionsanlagen gemäß dem Oberbegriff des Patentanspruches 1 und ein System zum Managen von Alarmen in modularen Produktionsanlagen gemäß dem Oberbegriff des Patentanspruches 5.

Modulare Produktionsanlagen kommen in der Fertigungs- und Verfahrenstechnik zunehmend zum Einsatz, bei dem die Fertigungs- und Verfahrenstechnik und modulare Automation vernetzt werden. Mit dem modularen Aufbau lassen sich Planungszeit und Engineering-Aufwände sowohl von neuen Anlagen als auch beim Umbau bestehender Anlagen deutlich reduzieren. Gerade in Bezug auf die Umbauarbeiten "alter" Anlagensollen spielt rasche Durchführung eine wesentliche Rolle, wenn es darum geht, Stillstandzeiten als auch die Zeit für ein Time-to-Market zu verkürzen. Ein modulares Engineering im Hinblick auf eine modulare Automatisierung war bislang häufig nicht möglich, weil Steuerungen unterschiedlicher Hersteller in einer Produktionsanlage nicht verwendet werden konnten.

Um jedoch ein durchgängiges modulares Engineering und eine modulare Automatisierung zu ermöglichen, wird mit einer VDI/VDE/Namur-Richtlinie 2658 ein Standard definiert, in dem "Process Equipment Assembly <PEA>"-Module, durch den die PEA-Modul-Automatisierung herstellerunabhängig beschrieben werden kann und es können PEA-Module verschiedener Hersteller mit PEA-Steuerungen im Zuge einer Prozess Orchestrierung in einen "Process Orchestration Layer <POL>" integriert werden. Die Integration der PEA-Module erfolgt dabei über einen "Module Type Package <MTP>"-Mechanismus, der vom PEA-Hersteller erzeugt wird und mit dem alle notwendigen Informationen einer "Process Equipment Assembly <PEA>", ein PEA-Bedienbild als Strukturbeschreibung, Dienste als gekapselte Prozessfunktionalitäten und z.B. Alarm- und Diagnose-Aspekte beschrieben werden.

In modularen Produktionsanlagen wird darüber hinaus ein Alarmmanagement immer wichtiger, da sich die Anlagenstruktur häufig ändert und somit ein Erfahrungsaufbau sich schwieriger darstellt. Eine Möglichkeit dies zu verbessern, ist ein Modell zur Beschreibung von Alarmketten, das ebenfalls in dem Standard VDI/VDE/NAMUR 2658 definiert wird. Dieses Modell kann von den PEA-Modulen benutzt werden, um die modulinternen Alarmketten zu beschreiben und die Alarmketten sowohl einer Produktionsanlage-Steuerung als auch einem Betreiber der Produktionsanlage zur Verfügung zu stellen. Dazu ist aber notwendig, dass der PEA-Hersteller erst die Alarmketten ermitteln und die ermittelten Alarmketten dann in das standardisierte Format umsetzen muss.

Eine Möglichkeit dies zu erreichen besteht darin, dass der PEA-Hersteller durch sein Expertenwissen und durch manuelle Ableitung der Alarmketten diese entsprechend ermittelt und danach manuell die Erfassung gemäß dem Standard vornimmt.

Die der Erfindung zugrundeliegende Aufgabe besteht darin, ein Verfahren und ein System zum Managen von Alarmen in modularen Produktionsanlagen anzugeben, mit dem das Alarmmanagement in modularen Produktionsanlagen automatisiert wird.

Diese Aufgabe wird ausgehend von dem im Oberbegriff des Patentanspruchs 1 definierten dem Verfahren durch die im Kennzeichen des Patentanspruches 1 angegebenen Merkmale gelöst.

Darüber hinaus wird die Aufgabe ausgehend von dem im Oberbegriff des Patentanspruchs 5 definierten System durch die im Kennzeichen des Patentanspruches 5 angegebenen Merkmale gelöst.

Die der Erfindung gemäß den unabhängigen Ansprüchen 1 und 5 zugrundeliegenden Idee besteht darin, in Bezug auf eine modulare Produktionsanlage, z.B. eine Industrieautomatisierungsanlage (*vgl. Ansprüche 4 und 8*), bei der für deren modularen, herstellerunabhängigen Aufbau und Betrieb "Process Equipment Assembly <PEA>"-Module (PEA-MD), gesteuert durch eine programmierbare PEA-Steuerung (PEA-ST) und simuliert mit einer projektierbaren PEA-Simulation (PEA-SM), im Zuge einer, insbesondere nach dem Standard VDI/VDE/NAMUR 2658, standardisierten Prozess-Orchestrierung (PO) durch einen "Module Type Package <MTP>"-Mechanismus (MTP-MC) zur PEA-Modulbeschreibung in die Produktionsanlage (PRAL) integriert werden, beim Alarmmanagement
- alle Zustände der modularen Produktionsanlage in Bezug auf ausgelöste Fehler möglicher Fehlerfälle der Produktionsanlage virtuell abzufahren und zu simulieren,
- die dabei auftretenden Simulationsfehler durch kenntlichmachende, z.B. durch Signalgebung, Alarme in Form von Alarmmeldungen begleitend zu protokollieren und ein Alarmmeldungsprotokoll zu erstellen sowie
- aus dem Alarmmeldungsprotokoll Alarmketten zu identifizieren oder Alarmketten zu identifizieren und Alarmzusammenhänge in den Alarmketten zu ermitteln.

Im Detail besteht das Alarmmanagement aus den folgenden sieben Maßnahmen:
(1) virtuellem Auslösen von in Bezug auf potenzielle, bekannte und abrufbare Fehlerfälle der Produktionsanlage korrespondierenden Fehlern, wobei für jeden Fehlerfall der Fehler durch eine entsprechende PEA-Modulanregung bei der PEA-Simulation virtuell ausgelöst wird,
(2) Simulieren eines zu dem jeweils virtuell ausgelösten Fehler gehörenden Simulationsfalls durch die PEA-Simulation, bei dem jeweils mindestens ein Simulationsfehler ermittelt wird,
(3) Erkennen des Simulationsfehlers durch die programmierbare PEA-Steuerung, die daraufhin alle simulationsfehlerbasierten Schalthandlungen entsprechend deren Programmierung ausführt,
(4) Erzeugen von mindestens einer Alarmmeldung zur Alarmkettenverfolgung für jeden erkannten Simulationsfehler durch die PEA-Steuerung,
(5) Erfassen der für alle Fehlerfälle erzeugten Alarmmeldungen und Protokollieren der Alarmmeldungen durch Erstellen eines Alarmmeldungsprotokolls,
(6) Analysieren des Alarmmeldungsprotokolls und auf der Basis dieser Analyse Identifizieren von Alarmketten oder Identifizieren von Alarmketten und Ermitteln von Alarmzusammenhängen in den Alarmketten,
(7) Übergeben von Analyseergebnisse und/oder Ermittlungsergebnisse an den "Module Type Package <MTP>"-Mechanismus zu deren Einbettung in die PEA-Modulbeschreibung.

So können in einem Alarmmanagementsystem die Alarmmanagement-Maßnahmen (1) und (5) in einer Alarmketten-Verfolgungskomponente, die Alarmmanagement-Maßnahme (2) im Zuge der PEA-Simulation auf einer Simulationsplattform, z.B. vom Typ SIMIT, die Alarmmanagement-Maßnahmen (3) und (4) im Zuge der PEA-Steuerung auf einer "Speicherprogrammierbaren Steuerung <SPS>"-Plattform, z.B. vom Typ SIMATIC S7-1500, und die Alarmmanagement-Maßnahmen (6 und (7) in einer Alarmketten-Analysekomponente ausgeführt werden.

Die Alarmketten-Verfolgungskomponente und die Alarmketten-Analysekomponente sind dabei vorzugsweise
- gemäß dem Anspruch 6 im Zuge des Alarmmanagements in der modularen Produktionsanlage Bestandteil eines Programm-Moduls mit Steuerprogrammbefehlen, die in einem nicht-flüchtigen, lesbaren Speicher eines computerimplementiertes Werkzeug, das vorzugsweise ein z.B. als APP ausgebildetes Computer-Programm-Produkt ist und neben dem Speicher einen mit dem Speicher verbundenen Prozessor aufweist, der die Steuerprogrammbefehle des Programm-Moduls ausführt, und/oder
- gemäß dem Anspruch 7 in ein Produktionsanlagen-Testsystem, z.B. einem "Factory Acceptance Tool <FAT>" enthalten.

Die Alarmketten-Verfolgungskomponente, die z.B. als ein Alarmketten-Tracer ausgebildet ist, sorgt für das gezielte Konfigurieren und Durchspielen jedes einzelnen Fehlerszenarios und erfasst und protokolliert durch die von der PEA-Steuerung erzeugten und erhaltenen Alarmmeldungen alle auftretenden Alarme in ihrer zeitlichen Reihenfolge. Nach dem Durchlaufen aller Fehlerszenarien werden das Alarmmeldungsprotokoll mit den protokollierten Alarmmeldungen von der Alarmketten-Verfolgungskomponente bzw. dem Alarmketten-Tracer an die Alarmketten-Analysekomponente, die z.B. als Alarmketten-Analyzer ausgebildet ist, weitergegeben. Diese Alarmketten-Analysekomponente bzw. der Alarmketten-Analyzer analysiert das Alarmmeldungsprotokoll und identifiziert daraus die Alarmkette und übergibt dabei den Standard VDI/VDE/NAMUR 2658 die identifizierte Alarmkette an den "Module Type Package <MTP>"-Mechanismus zu Einbettung der Alarmkette in die PEA-Modulbeschreibung.

Das auf diese Weise durchgeführte Alarmmanagement zeichnet sich in vorteilhafter Weise dadurch aus, dass
- die Alarmketten automatisiert erfasst und in richtigem Format abgelegt werden.
- die Alarmketten vollständig erfasst werden, da durch das Simulieren aller Fehlerzustände in der PEA-Simulation mittels eines digitalen Zwillings der Produktionsanlage, der aus einem Modell von Sensoren und Aktoren sowie Prozessen und einer emulierten PEA-Automatisierung besteht, eine Alarmkette ausgelöst wird, die zu einer Alarmkette in der "echten" Produktionsanlage identisch ist.
- sowohl lineare als auch verkettete Alarmketten bestimmt werden können.
- wenn Änderungen in einem "Programmable Logic Controller <PLC>" am PLC-Code vorgenommen werden, so erfordert dies nur ein erneutes Durchführen der vorstehenden automatisierten Alarmmanagement-Maßnahmen und es bedarf keiner manuellen Analysen, was sich durch die vorgenommenen Änderungen geändert hat und welche Auswirkungen diese haben.

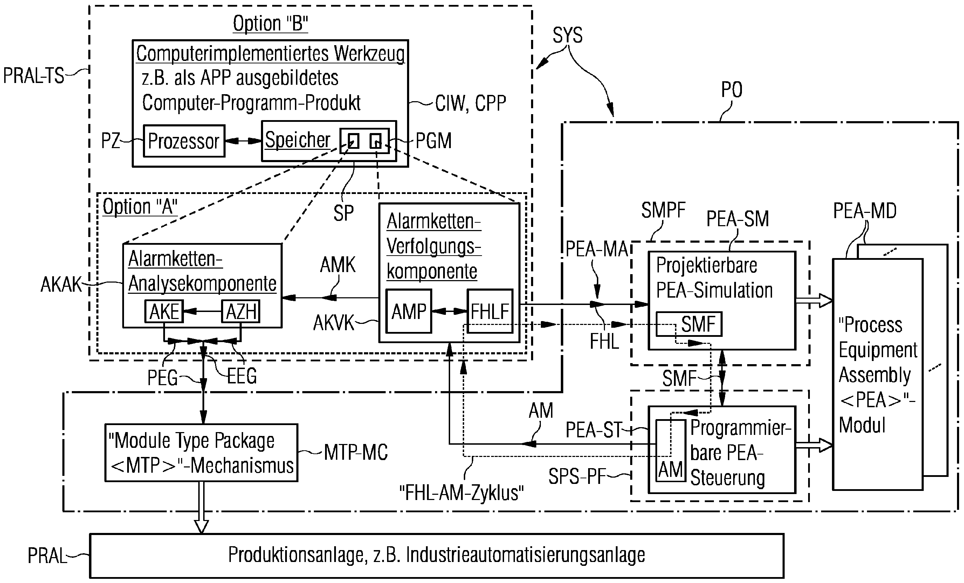

Weitere Vorteile der Erfindung ergeben sich aus der nachfolgenden Beschreibung von zwei Ausführungsbeispielen der Erfindung anhand der einzigen FIGUR erläutert. Diese zeigt:
FIGUR ein System zum Managen von Alarmen in einer modularen Produktionsanlage.

Die FIGUR zeigt ein System SYS zum Managen von Alarmen in einer modularen Produktionsanlage PRAL, die z.B. als Industrieautomatisierungsanlage ausgebildet ist. Für das Alarmmanagement weist das System SYS folgende Systemkomponenten auf:
**(i)** "Process Equipment Assembly <PEA>"-Module PEA-MD für einen modularen, herstellerunabhängigen Aufbau und Betrieb der Produktionsanlage PRAL,
**(ii)** eine "Speicherprogrammierbare Steuerung <SPS>"-Plattform SPS-PF, z.B. vom Typ SIMATIC S7-1500, auf der eine programmierbare, die <PEA>"-Module PEA-MD steuernde PEA-Steuerung PEA-ST ausführbar ist,
**(iii)** eine Simulationsplattform SPF, z.B. vom Typ SIMIT, auf der eine projektierbare (z.B. für das Alarmmanagement), die <PEA>"-Module PEA-MD simulierende PEA-Simulation PEA-ST ausführbar ist und die mit der SPS-Plattform SPS-PF funktionellbidirektional verbunden ist,
**(iv)** einen "Module Type Package <MTP>"-Mechanismus (MTP-MC), durch den die PEA-Module PEA-MD im Zuge einer, vorzugsweise nach dem Standard VDI/VDE/NAMUR 2658, standardisierten Prozess-Orchestrierung PO zur PEA-Modulbeschreibung in die Produktionsanlage PRAL integriert werden und
**(v)** ein Produktionsanlagen-Testsystem PRAL-TS, z.B. ein "Factory Acceptance Tool <FAT>", in dem
   - gemäß einer Option "A" eine Alarmketten-Verfolgungskomponente AKVK und eine Alarmketten-Analysekomponente AKAK enthalten sind, die für das Alarmmanagement funktional zusammenwirken, oder
   - gemäß einer Option "B" ein computerimplementiertes Werkzeug CIW, das z.B. ein vorzugsweise als APP ausgebildetes Computer-Programm-Produkt CPP ist, mit einem nicht-flüchtigen, lesbaren Speicher SP, in dem prozessorlesbare Steuerprogrammbefehle eines Programm-Moduls PGM gespeichert sind, und einem mit dem Speicher SP verbundenen Prozessor PZ, der die Steuerprogrammbefehle des Programm-Moduls PGM ausführt, wobei das Programm-Modul PGM im Zuge des Alarmmanagements die funktional zusammenwirkenden Alarmketten-Verfolgungskomponente AKVK und Alarmketten-Analysekomponente AKAK enthält.

Gemäß der Option "A" sind die Alarmketten-Verfolgungskomponente AKVK und die Alarmketten-Analysekomponente AKAK als Hardwarekomponenten des Systems SYS (Hardware-Systemkomponenten), während gemäß der Option "B" sind die Alarmketten-Verfolgungskomponente AKVK und die Alarmketten-Analysekomponente AKAK als Softwarekomponenten des Systems SYS (SoftwareSystemkomponenten) in dem Programm-Modul PGM des als APP ausgebildeten computerimplementierten Werkzeugs CIW respektive des Computer-Programm-Produkts CPP enthalten.

In beiden Fällen sind - wie in der FIGUR dargestellt - die entweder als Hardwaresystemkomponenten oder als Softwaresystemkomponenten ausgebildeten Alarmketten-Verfolgungskomponente AKVK und Alarmketten-Analysekomponente AKAK Bestandteil des Produktionsanlagen-Testsystems PRAL-TS. Es ist aber durchaus auch möglich, wenngleich nicht explizit dargestellt, die Hardwaresystemkomponenten oder Softwaresystemkomponenten im Zuge des Alarmmanagements autonom von dem Produktionsanlagen-Testsystem PRAL-TS zu betreiben.

Im Zuge dieses Alarmmanagements und der standardisierten Prozess-Orchestrierung PO wird in der Alarmketten-Verfolgungskomponente AKVK für das Alarmmanagement in Bezug auf alle in Frage kommenden oder potenziellen Fehlerfälle FHLF der Produktionsanlage PRAL mit korrespondierenden Fehlern FHL, die in der Alarmketten-Verfolgungskomponente AKVK gespeichert oder von dieser abrufbar sind, im Rahmen eines "Fehler <FHL>-Alarmmeldung <AM>-Zyklus" für jeden Fehlerfall der entsprechende Fehler durch eine entsprechende PEA-Modulanregung PEA-MA bei der PEA-Simulation PEA-SM auf der Simulationsplattform SPF virtuell ausgelöst.

Die PEA-Simulation PEA-SM auf der Simulationsplattform SPF simuliert daraufhin im Rahmen des "Fehler <FHL>-Alarmmeldung <AM>-Zyklus" einen zu dem jeweils virtuell ausgelösten Fehler gehörenden Simulationsfall und ermittelt dabei jeweils mindestens einen Simulationsfehler SMF ermittelt.

Die programmierbare PEA-Steuerung PEA-ST auf der SPS-Plattform SPS-PF erkennt wieder im Rahmen des "Fehler <FHL>-Alarmmeldung <AM>-Zyklus" über die funktionell-bidirektionale Verbindung mit der PEA-Simulation PEA-SM auf der Simulationsplattform SPF den Simulationsfehler SMF und führt daraufhin alle simulationsfehlerbasierten Schalthandlungen entsprechend deren Programmierung aus. Anschließend erzeugt die programmierbare PEA-Steuerung PEA-ST auf der Basis der ausgeführten simulationsfehlerbasierten Schalthandlungen zur Alarmkettenverfolgung mindestens eine Alarmmeldung AM für jeden erkannten Simulationsfehler SMF.

Abschließend, im Rahmen des "Fehler <FHL>-Alarmmeldung <AM>-Zyklus" erfasst die Alarmketten-Verfolgungskomponente AKVK die die für alle Fehlerfälle FHLF erzeugten Alarmmeldungen AM, protokolliert diese in einem Alarmmeldungsprotokoll AMP und übergibt das Alarmmeldungsprotokoll AMP an die Alarmketten-Analysekomponente AKAK.

In der Alarmketten-Analysekomponente AKAK wird das Alarmmeldungsprotokoll AMP zunächst analysiert und dann werden auf der Basis dieser Analyse Alarmketten AKE identifiziert.

Alternativ dazu ist aber auch möglich, dass in der Alarmketten-Analysekomponente AKAK wieder das Alarmmeldungsprotokoll AMP zunächst analysiert wird und dann werden auf der Basis dieser Analyse wieder Alarmketten AKE identifiziert und zusätzlich Alarmzusammenhänge AZH in den Alarmketten AKE ermittelt.

Als Ergebnisse der Analyse oder der Analyse und der Ermittlung erzeugt die Alarmketten-Analysekomponente AKAK Analyseergebnisse AEG und/oder Ermittlungsergebnisse EEG und übergibt diese an den "Module Type Package <MTP>"-Mechanismus MTP-MC zu deren Einbettung in die PEA-Modulbeschreibung.

## Patentansprüche

1. Verfahren zum Managen von Alarmen in modularen Produktionsanlagen, bei dem für einen modularen, herstellerunabhängigen Aufbau und Betrieb einer Produktionsanlage (PRAL) "Process Equipment Assembly <PEA>"-Module (PEA-MD), gesteuert durch eine programmierbare PEA-Steuerung (PEA-ST) und simuliert mit einer projektierbaren PEA-Simulation (PEA-SM), im Zuge einer, insbesondere nach dem Standard VDI/VDE/NAMUR 2658, standardisierten Prozess-Orchestrierung (PO) durch einen "Module Type Package <MTP>"-Mechanismus (MTP-MC) zur PEA-Modulbeschreibung in die Produktionsanlage (PRAL) integriert werden,
**gekennzeichnet durch**
**a)** virtuelles Auslösen von in Bezug auf potenzielle, gespeicherten oder abrufbaren Fehlerfälle (FHLF) der Produktionsanlage (PRAL) korrespondierenden Fehlern (FHL), wobei für jeden Fehlerfall der korrespondierende Fehler **durch** eine entsprechende PEA-Modulanregung (PEA-MA) bei der PEA-Simulation (PEA-SM) virtuell ausgelöst wird,
**b)** Simulieren eines zu dem jeweils virtuell ausgelösten Fehler gehörenden Simulationsfalls **durch** die PEA-Simulation (PEA-SM), bei dem jeweils mindestens ein Simulationsfehler (SMF) ermittelt wird,
**c)** Erkennen des Simulationsfehlers (SMF) **durch** die programmierbare PEA-Steuerung (PEA-ST), die daraufhin alle simulationsfehlerbasierten Schalthandlungen entsprechend deren Programmierung ausführt,
**d)** Erzeugen von mindestens einer Alarmmeldung (AM) zur Alarmkettenverfolgung für jeden erkannten Simulationsfehler (SMF) **durch** die PEA-Steuerung (PEA-ST),
**e)** Erfassen der für alle Fehlerfälle (FHLF) erzeugten Alarmmeldungen (AM) und Protokollieren der Alarmmeldungen (AM) **durch** Erstellen eines Alarmmeldungsprotokolls (AMP),
**f)** Analysieren des Alarmmeldungsprotokolls (AMP) und auf der Basis dieser Analyse Identifizieren von Alarmketten (AKE) oder Identifizieren von Alarmketten (AKE) und Ermitteln von Alarmzusammenhängen (AZH) in den Alarmketten (AKE),
**g)** Übergeben von Analyseergebnisse (AEG) und/oder Ermittlungsergebnisse (EEG) an den "Module Type Package <MTP>"-Mechanismus (MTP-MC) zu deren Einbettung in die PEA-Modulbeschreibung.

2. Verfahren nach Anspruch 1, **dadurch gekennzeichnet, dass**
die Verfahrensschritte a), e) f) und g) computerimplementiert durchgeführt werden.

3. Verfahren nach Anspruch 1 oder 2, **dadurch gekenn-zeichnet,** dass
die Verfahrensschritte a), e) f) und g) von einem Produktionsanlagen-Testsystem (PRAL-TS), z.B. einem "Factory Acceptance Tool <FAT>", durchgeführt werden.

4. Verfahren nach einem der Ansprüche 1 bis 3, **dadurch gekennzeichnet, dass**
die Produktionsanlage (PRAL) eine Industrieautomatisierungsanlage ist.

5. System (SYS) zum Managen von Alarmen in modularen Produktionsanlagen, mit
- "Process Equipment Assembly <PEA>"-Modulen (PEA-MD) für einen modularen, herstellerunabhängigen Aufbau und Betrieb einer Produktionsanlage (PRAL),
- einer programmierbaren PEA-Steuerung (PEA-ST), die auf einer "Speicherprogrammierbaren Steuerung <SPS>"-Plattform (SPS-PF), z.B. vom Typ SIMATIC S7-1500, ausführbar ist und durch die die PEA-Module (PEA-MD) gesteuert werden,
- einer projektierbaren PEA-Simulation (PEA-SM), die auf einer Simulationsplattform (SPF), z.B. vom Typ SIMIT, ausführbar ist und mit der und die PEA-Module (PEA-MD) simuliert werden, und
- einem "Module Type Package <MTP>"-Mechanismus (MTP-MC), durch den die PEA-Module (PEA-MD) im Zuge einer, insbesondere nach dem Standard VDI/VDE/NAMUR 2658, standardisierten Prozess-Orchestrierung (PO) zur PEA-Modulbeschreibung in die Produktionsanlage (PRAL) integriert werden, **gekennzeichnet durch**
**a)** eine Alarmketten-Verfolgungskomponente (AKVK) zum virtuellen Auslösen von in Bezug auf potenzielle, gespeicherte oder abrufbare Fehlerfälle (FHLF) der Produktionsanlage (PRAL) korrespondierenden Fehlern (FHL), wobei für jeden Fehlerfall der korrespondierende Fehler **durch** eine entsprechende PEA-Modulanregung (PEA-MA) bei der PEA-Simulation (PEA-SM) virtuell ausgelöst wird,
**b)** die PEA-Simulation (PEA-SM), die einen zu dem jeweils virtuell ausgelösten Fehler gehörenden Simulationsfall simuliert und dabei jeweils mindestens einen Simulationsfehler (SMF) ermittelt,
**c)** die programmierbare PEA-Steuerung (PEA-ST), die den Simulationsfehler (SMF) erkennt und daraufhin alle simulationsfehlerbasierten Schalthandlungen entsprechend deren Programmierung ausführt,
**d)** die programmierbare PEA-Steuerung (PEA-ST), die zur Alarmkettenverfolgung mindestens eine Alarmmeldung (AM) für jeden erkannten Simulationsfehler (SMF) erzeugt,
**e)** die Alarmketten-Verfolgungskomponente (AKVK), die die für alle Fehlerfälle (FHLF) erzeugten Alarmmeldungen (AM) erfasst, in einem Alarmmeldungsprotokoll (AMP) protokolliert und das Alarmmeldungsprotokoll (AMP) an eine Alarmketten-Analysekomponente (AKAK) übergibt,
f) die Alarmketten-Analysekomponente (AKAK), die das Alarmmeldungsprotokoll (AMP) analysiert und auf der Basis dieser Analyse Alarmketten (AKE) identifiziert oder Alarmketten (AKE) identifiziert und Alarmzusammenhänge (AZH) in den Alarmketten (AKE) ermittelt,
**g)** die Alarmketten-Analysekomponente (AKAK), die Analyseergebnisse (AEG) und/oder Ermittlungsergebnisse (EEG) an den "Module Type Package <MTP>"-Mechanismus (MTP-MC) zu deren Einbettung in die PEA-Modulbeschreibung übergibt.

6. System (SYS) nach Anspruch 5, **gekennzeichnet durch** ein computerimplementiertes Werkzeug (CIW), insbesondere ein z.B. als APP ausgebildetes Computer-Programm-Produkt (CPP), mit einem nicht-flüchtigen, lesbaren Speicher (SP), in dem prozessorlesbare Steuerprogrammbefehle eines Programm-Moduls (PGM) gespeichert sind, und einem mit dem Speicher (SP) verbundenen Prozessor (PZ), der die Steuerprogrammbefehle des Programm-Moduls (PGM) ausführt, wobei das Programm-Modul (PGM) im Zuge des Alarmmanagements die Alarmketten-Verfolgungskomponente (AKVK) und die Alarmketten-Analysekomponente (AKAK) enthält.

7. System (SYS) nach Anspruch 5 oder 6, **gekennzeichnet durch**
ein Produktionsanlagen-Testsystem (PRAL-TS), z.B. einem "Factory Acceptance Tool <FAT>", in dem die Alarmketten-Verfolgungskomponente (AKVK) und die Alarmketten-Analysekomponente (AKAK) enthalten sind.

8. System (SYS) nach einem der Ansprüche 5 bis 7, **dadurch gekennzeichnet, dass**
die Produktionsanlage (PRAL) eine Industrieautomatisierungsanlage ist.
